# EUROPEAN PATENT APPLICATION

(11) **EP 4 583 082 A1**
(43) Date of publication of application: **09.07.2025**
(21) Application number: 23860752.7
(22) Date of filing: 21.08.2023
(51) Int. Cl.: G09F 9/30, G06F 1/16, H04M 1/02, H10K 50/84, H10K 102/00

(54) **DISPLAY DEVICE**

(30) Priority: 01.09.2022 KR 20220110685
(71) Applicant: Samsung Display Co., Ltd., Yongin-si, Gyeonggi-do 17113 (KR)
(72) Inventor: HAN, Soh Ra, Yongin-Si Gyeonggi-do 17113 (KR); LEE, Yong Hyuck, Yongin-Si Gyeonggi-do 17113 (KR); LEE, Hong Kwan, Yongin-Si Gyeonggi-do 17113 (KR); CHO, Hyun Jun, Yongin-Si Gyeonggi-do 17113 (KR); KIM, Min Ji, Yongin-Si Gyeonggi-do 17113 (KR); EO, Sung Woo, Yongin-Si Gyeonggi-do 17113 (KR); CHOI, Eun Gil, Yongin-Si Gyeonggi-do 17113 (KR); HAN, Sang Woo, Yongin-Si Gyeonggi-do 17113 (KR)
(74) Representative: Dr. Weitzel & Partner
(86) International application number: PCT/KR2023/012331
(87) International publication number: WO 2024/049074

(57) **Abstract**

Provided is a display device. According to an embodiment, a display device at least, includes a panel support disposed on a bottom surface of the display panel having a folding axis extending in a first direction. The panel support includes a first layer including a first base resin and first fiber yarns extending in the first direction and dispersed in the first base resin, a second layer disposed on the first layer, the second layer including a second base resin and second fiber yarns extending in a second direction intersecting the first direction and dispersed in the second base resin, and a third layer disposed on the second layer, the third layer including a third base resin and third fiber yarns extending in the first direction and dispersed in the third base resin. The number of second fiber yarns per unit volume of the second layer is greater than the number of first fiber yarns per unit volume of the first layer and the number of third fiber yarns per unit volume of the third layer.

## Description

### [Technical Field]

The present disclosure relates to a display device.

### [Background of the Invention]

The importance of a display device is increasing with the development of multimedia. Accordingly, various types of display devices such as an organic light emitting display (OLED) and a liquid crystal display (LCD) are being used.

Recently, with the development of display technology, research and development of display devices having flexible displays have been actively conducted. The flexible display may extend or reduce a display screen, for example, fold, bend, or slide the display screen, thereby significantly contributing to a decrease in volume or a change in design of the display device.

**In** this case, since a load of the display device itself may be reduced by using fiber reinforced plastics (FRP) as a panel support for supporting the flexible display of the display device, research and development on technologies for manufacturing the panel support with fiber reinforced plastics are being actively conducted.

### [Summary of the Invention]

### [Aspects to be Achieved by the Invention]

The problem to be solved by the present disclosure is to provide a display device capable of having an improved surface quality of a panel support.

The tasks of the present invention are not limited to the tasks mentioned above, and other technical tasks not mentioned will be clearly understood by those skilled in the art from the description below.

### [Means for Achieving the Aspects of the Invention]

A display device according to one embodiment of the present disclosure for solving the problem includes a display panel having a folding axis extending in a first direction; and a panel support disposed on one surface of the display panel. The panel support includes a first layer including a first base resin and first fiber yarns extending in the first direction and dispersed in the first base resin, a second layer disposed on the first layer, the second layer including a second base resin and second fiber yarns extending in a second direction intersecting the first direction and dispersed in the second base resin, and a third layer disposed on the second layer, the third layer including a third base resin and third fiber yarns extending in the first direction and dispersed in the third base resin. The number of second fiber yarns per unit volume of the second layer is greater than the number of first fiber yarns per unit volume of the first layer and the number of third fiber yarns per unit volume of the third layer.

A display device according to other embodiment of the present disclosure for solving the problem includes a display panel having a folding axis extending in a first direction, and a panel support disposed on one surface of the display panel. The panel support includes a first layer including a first base resin and first fiber yarns extending in the first direction and dispersed in the first base resin, a second layer disposed on the first layer, the second layer including a second base resin and second fiber yarns extending in a second direction intersecting the first direction and dispersed in the second base resin, and a third layer disposed on the second layer, the third layer including a third base resin and third fiber yarns extending in the first direction and dispersed in the third base resin. A modulus of the second fiber yarn is greater than a modulus of the first fiber yarn and a modulus of the third fiber yarn.

A display device according to another embodiment of the present disclosure for solving the problem includes a display panel having a folding axis extending in a first direction and a panel support disposed on one surface the display panel. The panel support includes a first layer including a first base resin and first fiber yarns extending in the first direction and dispersed in the first base resin, a second layer disposed on the first layer, the second layer including a second base resin and second fiber yarns extending in a second direction intersecting the first direction and dispersed in the second base resin, and a third layer disposed on the second layer, the third layer including a third base resin and third fiber yarns extending in the first direction and dispersed in the third base resin. A carbon content of the second fiber yarn is greater than a carbon content of the first fiber yarn and a carbon content of the third fiber yarn.

Specific details of other embodiments are included in the detailed description and drawings.

### [Effects of the Invention]

According to the display device according to one embodiment, a surface quality of the panel support may be improved.

The effects according to the embodiments are not limited to the contents exampled above, and more diverse effects are included in the present disclosure.

### [Brief Description of the Drawings]

FIG. 1 is a perspective view illustrating a display device according to an example embodiment.
FIG. 2 is a perspective view illustrating a state in which the display device according to an example embodiment is folded.
FIG. 3 is a side view schematically illustrating a structure of the display device according to an example embodiment.
FIG. 4 is a plan view schematically illustrating a panel support of the display device according to an example embodiment.
FIG. 5 is a cross-sectional view schematically illustrating a cross section taken along line X1-X1' of FIG. 4.
FIG. 6 is a cross-sectional view schematically illustrating a cross section taken along line X2-X2' of FIG. 4.
FIG. 7 is a view for describing a process of manufacturing the panel support of the display device according to an example embodiment.
FIG. 8 is an image obtained by photographing a cross-section of the panel support of the display device according to an example embodiment, viewed from a first direction.
FIG. 9 is an image obtained by photographing a cross-section of the panel support of the display device according to an example embodiment, viewed from a second direction.
FIG. 10 is a graph illustrating a surface step for each position of the panel support of the display device according to an example embodiment.
FIG. 11 is a cross-sectional view illustrating a structure of a panel support of a display device according to a comparative example.
FIG. 12 is a cross-sectional view illustrating a structure of a panel support of a display device according to a comparative example.
FIG. 13 is an image obtained by photographing a cross-section of the panel support of the display device according to an example embodiment, viewed from a second direction.
FIG. 14 is a graph illustrating a surface step for each position of a panel support of a display device according to an example embodiment.
FIG. 15 is a cross-sectional view illustrating a structure of a panel support of a display device according to another example embodiment.
FIG. 16 is a cross-sectional view illustrating a structure of the panel support of the display device according to the example embodiment of FIG. 15.
FIG. 17 is a graph illustrating a surface step for each position of the panel support of the display device according to the example embodiment of FIG. 15.

### [Detailed Description of the Preferred Embodiments]

The advantages and features of the present invention, and the methods for achieving them, will become clear with reference to the embodiments described in detail below with the accompanying drawings. However, the present invention is not limited to the embodiments disclosed below, but may be implemented in various different forms, and these embodiments are provided only to make the disclosure of the present invention complete and to fully inform those skilled in the art of the invention of the scope of the invention, and the present invention is defined only by the scope of the claims.

When elements or layers are referred to as "on" another element or layer, this includes all cases where another layer or another element is interposed directly on or in the middle of the other element. The same reference numerals refer to the same components throughout the specification. The shapes, sizes, ratios, angles, numbers, etc. disclosed in the drawings for explaining the embodiments are examples, and therefore the present invention is not limited to the matters illustrated.

Although the terms "first", "second", etc. are used to describe various components, these components are of course not limited by these terms. These terms are only used to distinguish one component from another. Therefore, it goes without saying that the first component mentioned below may also be the second component within the technical concept of the present invention.

Each of the features of the various embodiments of the present invention may be partially or wholly combined or combined with each other, and various technical connections and operations are possible, and each embodiment may be implemented independently of each other or may be implemented together in a related relationship.

Specific embodiments will be described below with reference to the attached drawings.

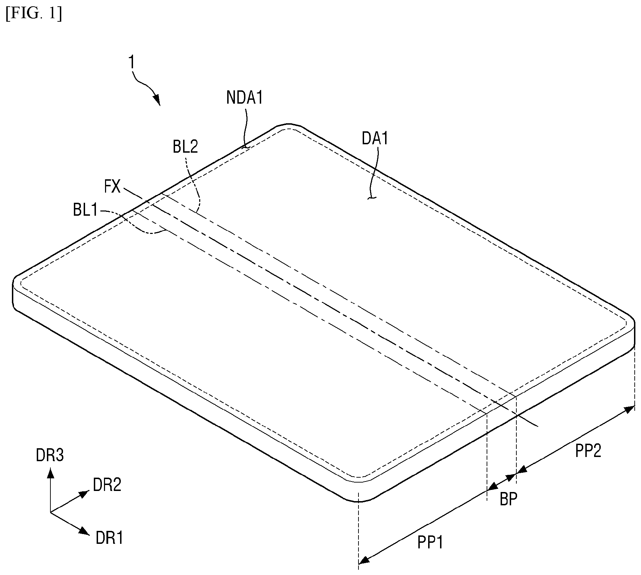

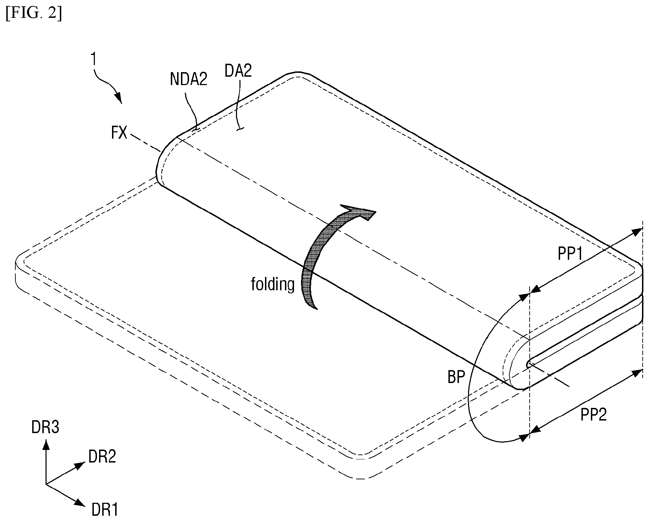

FIG. 1 is a perspective view illustrating a display device according to an example embodiment. FIG. 2 is a perspective view illustrating a state in which the display device according to an example embodiment is folded.

FIG. 1 illustrates a first state of the display device 1 that is unfolded without being bent with respect to a folding axis FX, and FIG. 2 illustrates a second state of the display device 1 bent with respect to the folding axis FX.

Referring to FIGS. 1 to 2, the display device 1 according to an example embodiment is a device that displays a moving image or a still image, and may be used as a display screen of various products such as televisions, laptops, monitors, billboards, and Internet of Things, as well as portable electronic devices such as mobile phones, smart phones, tablet PCs, smart watches, watch phones, mobile communication terminals, electronic organizers, e-books, PMPs, navigation, and UMPC.

In FIG. 1, a first direction DR1, a second direction DR2, and a third direction DR3 are defined. The first direction DR1 and the second direction DR2 may be perpendicular to each other, the first direction DR1 and the third direction DR3 may be perpendicular to each other, and the second direction DR2 and the third direction DR3 may be perpendicular to each other. It may be understood that the first direction DR1 means a vertical direction in the drawings, the second direction DR2 means a horizontal direction in the drawings, and the third direction DR3 means upper and lower directions in the drawings, that is, a thickness direction.

In the following specification, unless otherwise specified, the term "direction" may refer to both directions toward both sides extending along the direction. In addition, when both "directions" extending to both sides need to be distinguished from each other, one side will be referred to as "one side in the direction" and the other side will be referred to as "the other side in the direction". In FIG. 1, a direction in which an arrow indicating a direction is directed is referred to as one side, and an opposite direction thereof is referred to as the other side. However, it should be understood that the directions mentioned in the example embodiments refer to relative directions, and the example embodiments are not limited to the mentioned directions.

In addition, in referring to the surfaces of each member constituting the display device 1 without being bent with respect to the folding axis FX, one surface facing one side in a direction in which the image is displayed, that is, the third direction DR3 is referred to as a top surface, and an opposite surface of the one surface is referred to as a bottom surface. However, the present disclosure is not limited thereto, and the one surface and the other surface of the member may be referred to as a front surface and a bottom surface, respectively, or may also be referred to as a first surface or a second surface. In addition, in describing relative positions of the members of the display device 1, one side in the third direction DR3 may be referred to as an upper side and the other side in the third direction DR3 may be referred to as a lower side.

A planar shape of the display device 1 may have a rectangular shape in which a vertical side is longer than a horizontal side as illustrated in FIG. 1, and each of the corners of the display device 1 may have a right-angled planar shape or a rounded planar shape, but is not limited thereto. For example, the planar shape of the display device 1 may have a rectangular shape in which the vertical side is shorter than the horizontal side. FIG. 1 illustrates a rectangular shape in which the vertical side is longer than the horizontal side.

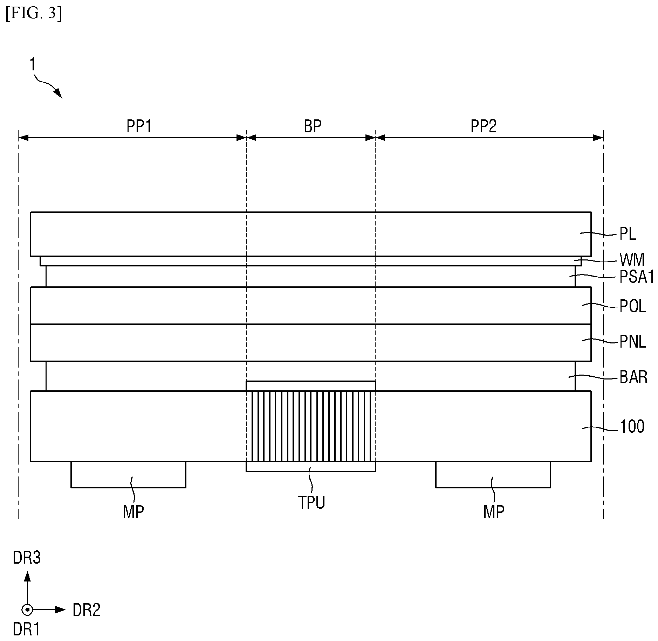

The display device 1 includes a first planarization portion PP1, a bending portion BP, and a second planarization portion PP2. The first planarization portion PP1, the bending portion BP and the second planarization portion PP2 defined in the display device 1 may also be applied to each component constituting the display device 1 as illustrated in FIG. 3.

The first planarization portion PP1 and the second planarization portion PP2 may be portions that are not bent. The first planarization portion PP1 may be disposed on the other side of the display device 1 in the second direction DR2 as a portion of the display device 1. The second planarization portion PP2 may be disposed on one side of the display device 1 in the second direction DR2 as a portion of the display device 2.

The bending portion BP may be disposed between the first planarization portion PP1 and the second planarization portion PP2. That is, the second planarization portion PP2 may be disposed on one side of the bending portion BP in the second direction DR2, and the first planarization portion PP1 may be disposed on the other side of the bending portion BP in the second direction DR2. A first bending line BL1 may be a boundary between the bending portion BP and the first planarization portion PP1, and the second bending line BL2 may be a boundary between the bending portion BP and the second planarization portion PP2.

The bending portion BP may be a bendable area. For example, the bending portion BP may be bent with respect to the folding axis FX disposed on the bending portion BP and extending in the first direction DR1. When the bending portion BP is not bent, the display device 1 may maintain an unfolded state (hereinafter, referred to as a 'first state') as illustrated in FIG. 1, and when the bending portion BP is bent, the display device 1 may maintain a folded state (hereinafter, referred to as a 'second state') as illustrated in FIG. 2.

The display device 1 includes a display area and a non-display area.

The display area may be an area in which pixels are disposed to display a screen. The display area may include a first display area DA1 and a second display area DA2. The non-display area may be an area that does not display a screen. The non-display area may include a first non-display area NDA1 and a second non-display area NDA2.

In the first state of the display device 1, one side surface of the display device 1 in the third direction DR3 may be a front surface on which the first display area DA1 and the first non-display area NDA1 are disposed, and the other surface of the display device 1 in the third direction DR3 may be a bottom surface on which the second display area DA2 and the second non-display area NDA2 are disposed.

The first display area DA1 may be disposed on one surface of the display device 1 in the third direction DR3 in the first state of the display device 1. A planar shape of the first display area DA1 may follow a planar shape of the display device 1 in the first state. For example, when the planar shape of the display device 1 in the first state is a rectangle, the planar shape of the first display area DA1 may also be a rectangle.

In some example embodiments, the first display area DA1 may be surrounded by the first non-display area NDA1, but is not limited thereto. For example, the first display area DA1 may be partially surrounded by the first non-display area NDA1. FIG. 1 illustrates that the first non-display area NDA1 surrounds the first display area DA1.

The second display area DA2 may be disposed on the other surface of the display device 1 in the third direction DR3 in the first state of the display device 1, and may overlap only the first planarization portion PP1, but is not limited thereto. The second display area DA2 may display a screen to the user when the display device 1 is in the second state.

The second display area DA2 may follow a planar shape of the first planarization portion PP1 visually recognized by the user in the display device 1 in the second state as illustrated in FIG. 2. For example, when the planar shape of the first planarization portion PP1 visually recognized by the user in the display device 1 in the second state is a rectangle, a planar shape of the second display area DA2 may also be a rectangle.

In some example embodiments, the second display area DA2 may be surrounded by the second non-display area NDA2, but is not limited thereto. For example, the second display area DA2 may be partially surrounded by the second non-display area NDA2.

As illustrated in FIG. 2, the display device 1 may be folded in an in-folding manner in which a portion of the first display area DA1 disposed on the first planarization portion PP1 and a portion of the first display area DA1 disposed on the second planarization portion PP2 are folded to face each other in the second state thereof, but is not limited thereto. For example, the display device 1 may be folded in an out-folding manner so that the bottom surfaces thereof face each other. FIG. 2 illustrates that the display device 1 is folded in an in-folding manner.

Hereinafter, a structure of the display device 1 will be described.

FIG. 3 is a side view schematically illustrating a structure of the display device according to an example embodiment.

Referring to FIG. 3, the display device 1 according to an example embodiment may include an upper protective member PL, a window member WM, a first adhesive member PSA1, a polarizing member POL, a display panel PNL, a barrier member BAR, a panel support 100, a lower visibility preventing member TPU, and a metal support MP.

The upper protective member PL may serve to perform at least one of scattering prevention, shock absorption, engraving prevention, fingerprint prevention, and glare prevention of the window member WM, which will be described later. The upper protective member PL may be disposed on one surface (hereinafter, referred to as a 'front surface') of the window member WM in the third direction DR3. The upper protective member PL may be attached to a front surface of the window member through an adhesive member such as a pressure-sensitive adhesive.

A light blocking pattern (not illustrated) may be formed on the other surface (hereinafter, referred to as a 'bottom surface') of the upper protective member PL in the third direction DR3. The light blocking pattern may be disposed at an edge of the upper protective member PL or adjacent to the edge. The light blocking pattern may include a light blocking material capable of blocking light. For example, the light blocking pattern may be an inorganic black pigment such as carbon black, an organic black pigment, or an opaque metal material.

The window member WM may serve to protect the display panel PNL, which will be described later, from the outside. The window member WM may be disposed on one side surface (hereinafter, referred to as a 'front surface') of the display panel PNL in the third direction DR3. The window member WM may be made of a transparent material, for example, glass or plastic.

The window member WM may be an ultra-thin glass having a thickness of approximately 0.1 mm or less or a transparent polyimide film. The window member WM may be attached to a front surface of the polarizing member POL by the first adhesive member PSA1. The first adhesive member PSA1 may be a transparent adhesive film or a transparent adhesive resin.

The polarizing member POL may prevent external light incident on the display panel PNL from being reflected. The polarizing member POL may be attached to the window member WM through the first adhesive member PSA1 as a medium. A display panel PNL may be disposed on a bottom surface of the polarizing member POL.

The display panel PNL is a panel that displays a screen, and any type of display panel such as an organic light emitting display panel including an organic light emitting layer, a micro light emitting diode (LED) display panel using a micro light emitting diode, a quantum dot light emitting display panel using a quantum dot light emitting diode including a quantum dot light emitting layer, and an inorganic light emitting display panel using an inorganic light emitting element including an inorganic semiconductor may be applied as the display panel PNL according to the present example embodiment. Referring to FIG. 1, the display panel PNL may display a screen on one side thereof in the third direction DR3.

The barrier member BAR may be disposed on the other side surface (hereinafter, referred to as a 'bottom surface') of the display panel PNL in the third direction DR3. A portion overlapping the bending portion BP among the other side surfaces of the barrier member BAR in the third direction DR3 may be spaced apart from a grid pattern disposed on the bending portion BP of the panel support 100 to be described later in the third direction DR3.

The barrier member BAR may include at least one of a light blocking layer for absorbing light incident from the outside, a buffer layer for absorbing a shock from the outside, and a heat dissipation layer for efficiently dissipating heat of the display panel PNL.

The light blocking layer blocks transmission of light and prevents components disposed on a lower side of the light blocking layer from being visually viewed from the front surface of the display panel PNL. The light blocking layer may include a light absorbing material such as a black pigment or a black dye.

The buffer layer absorbs the external shock to prevent the display panel PNL from being damaged. The buffer layer may be formed as a single layer or a plurality of layers. For example, the buffer layer may be formed of a polymer resin such as polyurethane, polycarbonate, polypropylene, or polyethylene or may include a material having elasticity, such as a sponge formed by foaming rubber, a urethane-based material, or an acrylic-based material.

The heat dissipation layer may include a first heat dissipation layer including graphite or carbon nano-tube, and a second heat dissipation layer formed of a thin metal film such as copper, nickel, ferrite, or silver that may shield electromagnetic waves and has excellent thermal conductivity.

The panel support 100 may serve to support the bottom surface of the display panel PNL. The panel support 100 may be disposed on the other surface (hereinafter, referred to as a 'bottom surface') of the barrier member BAR in the third direction DR3. The panel support 100 may be a rigid member whose shape or volume is not easily changed by external pressure. A grid pattern for easily bending the panel support 100 may be formed on the bending portion BP of the panel support 100.

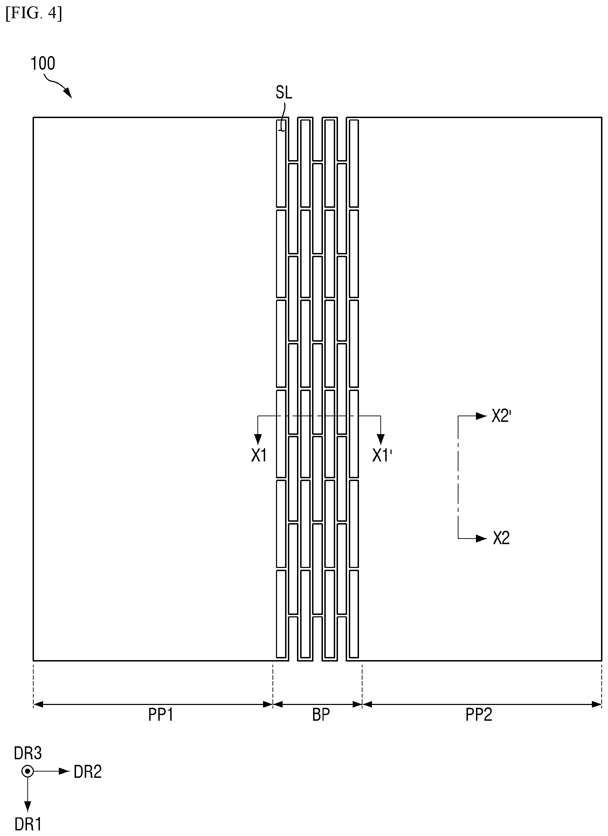

In some example embodiments, the panel support 100 may be carbon fiber reinforced plastic (CFRP) including carbon fibers, but is not limited thereto. For example, the panel support 100 may also be glass fiber reinforced plastic (GFRP) including glass fibers, or aramid fiber reinforced plastic (AFRP). Hereinafter, it will be mainly described that the panel support 100 is carbon fiber reinforced plastic. The structure of the panel support 100 will be described later in detail with reference to FIGS. 4 to 6.

The lower visibility preventing member TPU may be disposed on a bottom surface of the grid pattern formed on the bending portion BP of the panel support 100. The lower visibility preventing member TPU may prevent the grid pattern of the panel support 100 from being visually recognized to the outside. The lower visibility preventing member TPU may include a flexible material to reduce folding stress of the display device 1.

The metal support MP may be disposed on a bottom surface of each of the first planarization portion PP1 and the second planarization portion PP2 of the panel support 100. The metal support MP may serve to support the bottom surface of each of the first planarization portion PP1 and the second planarization portion PP2 of the panel support 100 and absorb heat generated from the display panel PNL. In some example embodiments, the metal support MP may include copper (Cu), but is not limited thereto. The metal support MP may not be disposed on the bending portion BP to reduce the folding stress of the display device 1.

Hereinafter, a structure of the panel support 100 of the display device 1 according to an example embodiment will be described with reference to FIGS. 4 to 10.

FIG. 4 is a plan view schematically illustrating a panel support of the display device according to an example embodiment.

Referring to FIG. 4, the panel support 100 of the display device 1 according to an example embodiment includes a first planarization portion PP1, a bending portion BP, and a second planarization portion PP2.

The first planarization portion PP1 and the second planarization portion PP2 of the panel support 100 may be portions that are not bent. The first planarization portion PP1 may be disposed on the other side of the panel support 100 in the second direction DR2 as a portion of the panel support 100. The second planarization portion PP2 may be disposed on one side of the panel support 100 in the second direction DR2 as a portion of the panel support 100.

The bending portion BP of the panel support 100 may be disposed between the first planarization portion PP1 and the second planarization portion PP2. That is, the second planarization portion PP2 may be disposed on one side of the bending portion BP in the second direction DR2, and the first planarization portion PP1 may be disposed on the other side of the bending portion BP in the second direction DR2.

The bending portion BP of the panel support 100 may be a bendable area. A grid pattern including a plurality of slits SL penetrating through the panel support 100 in the third direction DR3 may be formed on the bending portion BP. The plurality of slits SL are a plurality of columns arranged in the first direction DR1, and may have a shape in which each column is arranged in the second direction DR2. Accordingly, the bending portion BP of the panel support 100 may be easily bent.

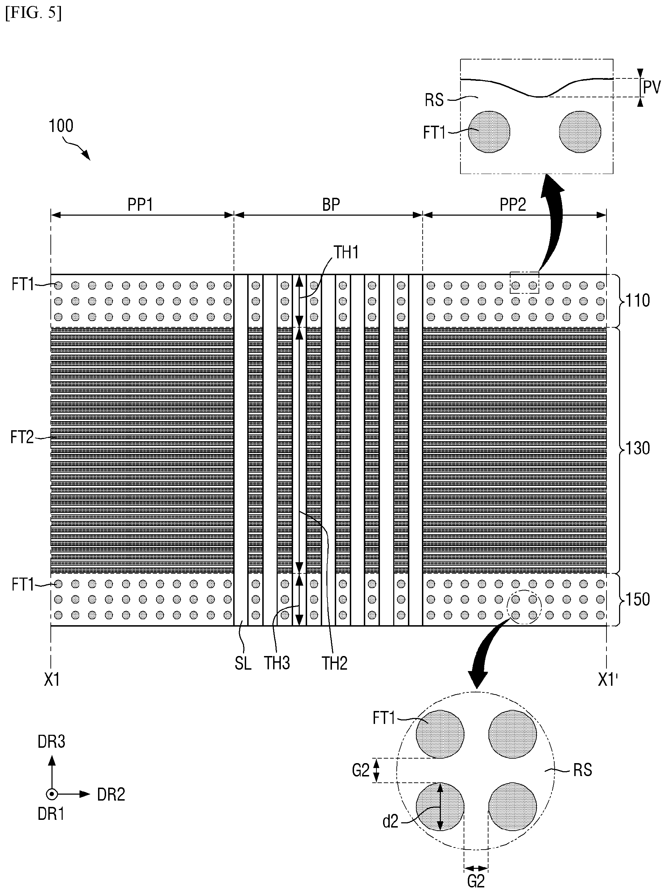

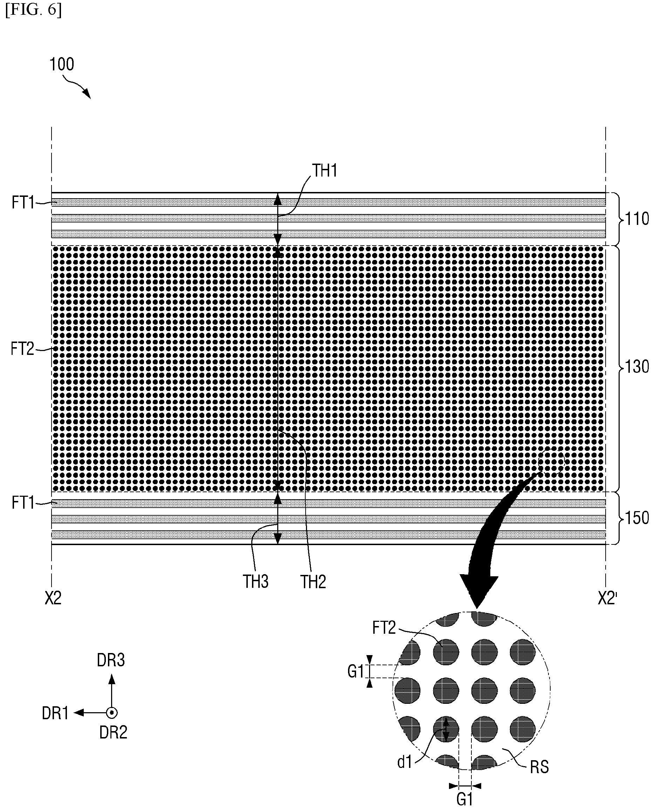

FIG. 5 is a cross-sectional view schematically illustrating a cross section taken along line X1-X1' of FIG. 4. FIG. 6 is a cross-sectional view schematically illustrating a cross section taken along line X2-X2' of FIG. 4.

Referring to FIGS. 5 and 6 together with FIG. 4, the panel support 100 may be fiber reinforced plastic including fiber yarns and a base resin RS. The fiber yarns may be dispersed in the base resin RS. The fiber yarn may include graphene as a carbon fiber containing carbon, and the base resin RS may be an epoxy-based resin, a polyester-based resin, a polyamide-based resin, a polycarbonate-based resin, a polypropylene-based resin, a polybutylene-based resin, a polyacrylate-based resin, or a vinyl ester-based resin.

The panel support 100 may include the first layer 110, the second layer 130, and the third layer 150 sequentially arranged in the other side in the third direction DR3. For example, the first layer 110 of the panel support 100 may be adjacent to the barrier member BAR (see FIG. 3) disposed on an upper side of the panel support 100, and the third layer 150 thereof may be adjacent to the lower visibility preventing member TPU (see FIG. 3) and the metal support MP (see FIG. 3) disposed on a lower side of the panel support 100.

The base resin RS may be integrally disposed in all of the first layer 110, the second layer 130, and the third layer 150 of the panel support 100. In the claims, a portion of the base resin RS disposed in the first layer 110 may be referred to as a first base resin, a portion of the base resin RS disposed in the second layer 130 may be referred to as a second base resin, and a portion of the base resin RS disposed in the third layer 150 may be referred to as a third base resin.

The fiber yarns may include first fiber yarns FT1 and second fiber yarns FT2 having different diameters, different elastic moduli, or different carbon contents. The first fiber yarns FT1 may be disposed in the first layer 110 and the third layer 150 of the panel support 100, and the second fiber yarns FT2 may be disposed in the second layer 130 of the panel support 100. In other words, the same type of fiber yarn as the first fiber yarns FT1 may be disposed in the first layer 110 and the third layer 150, and the different type of fiber yarns (for example, the second fiber yarns FT2) from the fiber yarn disposed in the first layer 110 and the third layer 150 as the second fiber yarn FT2 may be disposed in the second layer 130.

For example, the first layer 110 may be a prepreg including the first fiber yarns FT1 extending substantially in parallel in the first direction DR1 and a portion of the base resin RS surrounding the first fiber yarns FT1. The second layer 130 may be a prepreg including the second fiber yarns FT2 extending substantially in parallel in the second direction DR2 and a portion of the base resin RS surrounding the second fiber yarns FT2. For example, the first fiber yarns FT1 and the second fiber yarns FT2 are the different type of fiber yarns with each other. The third layer 150 may be a prepreg including the first fiber yarns FT1 extending substantially in parallel in the first direction DR1 and a portion of the base resin RS surrounding the first fiber yarns FT1.

In the present specification, the meaning of 'extending substantially in parallel in the first direction DR1' includes a case that extends that is completely parallel to the first direction DR1 or while forming an angle of intersection of approximately 15° or less by slightly intersecting the second direction DR2, and the meaning of 'extending substantially in parallel in the second direction DR2' includes a case that extends that is completely parallel to the second direction DR2 or while forming an angle of intersection of approximately 15° or less by slightly intersecting the first direction DR1.

The extending direction of the first fiber yarns FT1 disposed in the first layer 110 and the third layer 150 extends substantially in parallel in the first direction DR1, and the first direction DR1 is a direction parallel to the folding axis FX illustrated in FIGS. 1 and 2. Therefore, the first layer 110 and the third layer 150 may be easily folded when the display device 1 is switched from the first state to the second state. However, when the panel support 100 includes only the first fiber yarns FT1, the panel support 100 may be curved or bent in the first direction DR1. That is, when the panel support 100 includes only the first fiber yarns FT1, flatness and rigidity of the panel support 100 may be low.

Accordingly, as the panel support 100 further includes the second layer 130 having the second fiber yarns FT2 extending substantially in the second direction DR2, it is possible to prevent the panel support 100 from being curved or bent in the first direction DR1, and to increase the rigidity of the panel support 100.

However, in consideration of the rigidity required for the panel support 100, the content of the second fiber yarns FT2 of the panel support 100 may be greater than the content of the first fiber yarns FT1. For example, a width of the second layer 130 of the panel support 100 in the third direction DR3 may be greater than a width of the first layer 110 in the third direction DR3 and a width of the third layer 150 in the third direction DR3. The width of the first layer 110 in the third direction DR3 and the width of the third layer 150 in the third direction DR3 may be the same as each other. In some example embodiments, a thickness of the first layer 110 and a thickness of the third layer 150 may be approximately 20 µm, and a thickness of the second layer 130 may be approximately 100 µm, but the present disclosure is not limited thereto.

Meanwhile, as the fiber yarns extending in one direction are disposed in each layer as described above, it is possible to prevent the thickness of each layer itself from increasing. For example, when both the first fiber yarns FT1 and the second fiber yarns FT2 are disposed in any one layer of the panel support 100, portions at which the first fiber yarns T1 and the second fiber yarns FT2 intersect may occur, thereby increasing the thickness of the layer itself. Therefore, by disposing the fiber yarns extending only in one direction in each layer, the rigidity required for the panel support 100 may be secured while minimizing the thickness of the layer itself.

The first fiber yarn FT1 and the second fiber yarn FT2 may be made of carbon fiber and may have a cylindrical shape having a circular cross-section. A diameter d2 of the first fiber yarn FT1 may be greater than a diameter d1 of the second fiber yarn FT2. For example, the diameter d2 of the first fiber yarn FT1 may have a range of approximately 6.5 µm or more and approximately 7.5 µm or less, and the diameter d1 of the second fiber yarn FT2 may have a range of approximately 4.5 µm or more and approximately 5.5 µm or less. Accordingly, the number per unit volume of the first fiber yarns FT1 disposed in the first layer 110 and the third layer 150 may be smaller than the number per unit volume of the second fiber yarns FT2 disposed in the second layer 130. For example, comparing FIGS. 5 and 6, the number of fiber yarns disposed on the same area may be greater in the second layer 130 than in the first layer 110 or the third layer 150. In other words, a gap G1 at which the second fiber yarns FT2 are spaced apart from each other in the second layer 130 may be smaller than a gap G2 at which the first fiber yarns FT1 are spaced apart from each other in the first layer 110 or the third layer 150.

On the other hand, as the first layer 110 and the third layer 150 include the same type of fiber yarn, each layer of the panel support 100 may be manufactured without misalignment in a process of manufacturing the panel support 100 to be described later.

Since the second layer 130 is stronger than the first layer 110 and the third layer 150 by the configuration as described above, it is possible to reduce visual recognition of the first fiber yarns FT1 disposed in the first layer 110 and the third layer 150 to the outside.

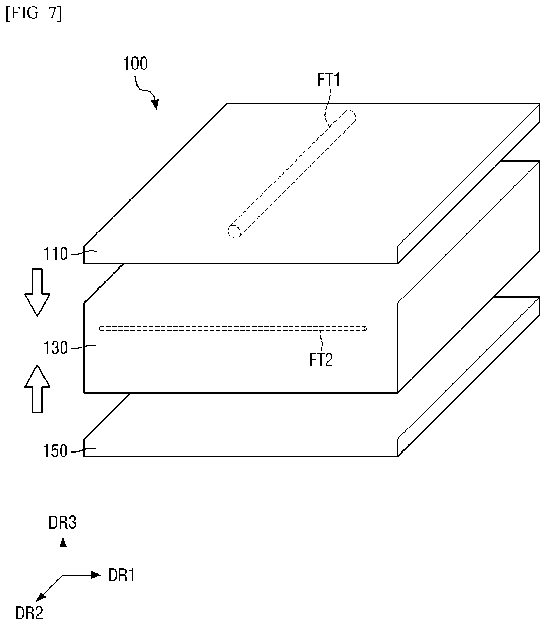

For example, as the base resin RS of the first layer 110 and the third layer 150 is thermally contracted in a process of stacking the first layer 110, the second layer 130, and the third layer 150 as described below, the surfaces of the first layer 110 and the third layer 150 have a bent shape, and a surface step PV as illustrated in FIG. 6 may be formed. The surface step PV may refer to a gap between a downwardly concave point and an upwardly convex point on the bent surface. Since the surface step PV is formed between the first fiber yarns FT1 disposed in the first layer 110 or the third layer 150, the surface step PV may generally have a shape extending in the first direction DR1. A detailed description thereof will be described with reference to FIGS. 7 to 14.

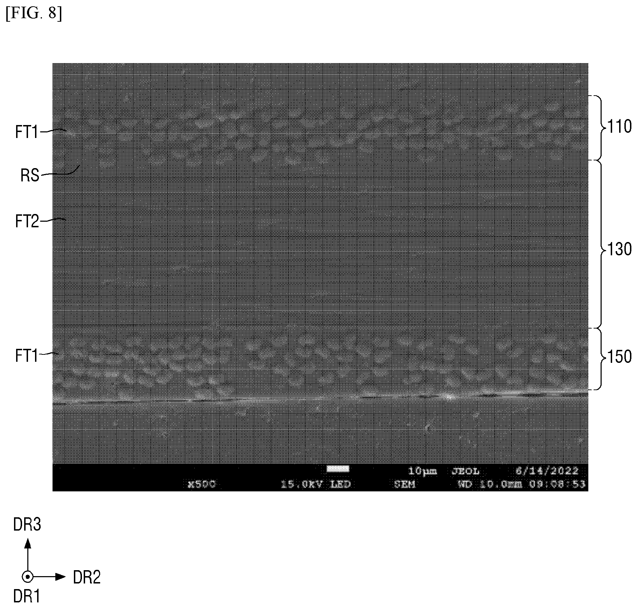

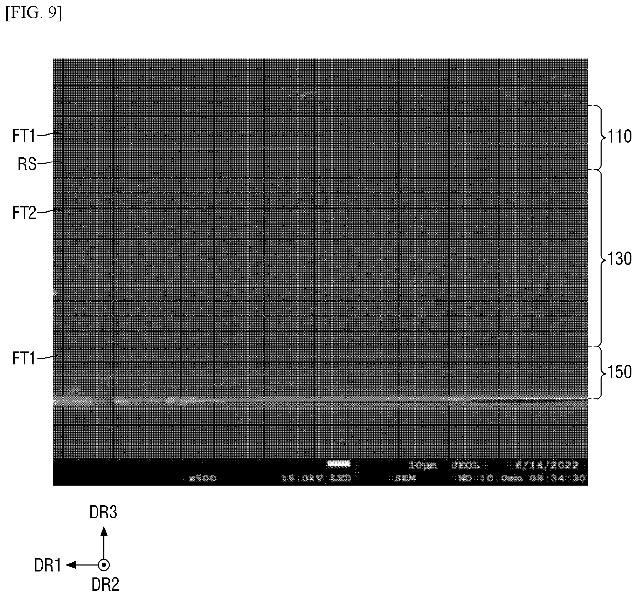

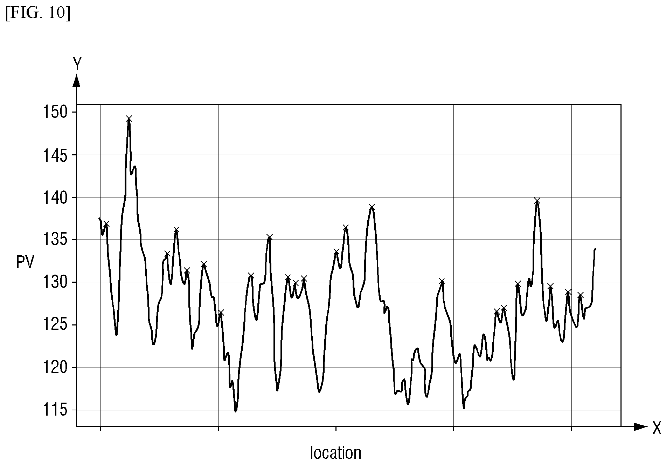

FIG. 7 is a view for describing a process of manufacturing the panel support of the display device according to an example embodiment. FIG. 8 is an image obtained by photographing a cross-section of the panel support of the display device according to an example embodiment, viewed from a first direction. FIG. 9 is an image obtained by photographing a cross-section of the panel support of the display device according to an example embodiment, viewed from a second direction. FIG. 10 is a graph illustrating a surface step for each position of the panel support of the display device according to an example embodiment.

Referring to FIG. 7, the first layer 110, the second layer 130, and the third layer 150 of the panel support 100 may be stacked by hot press or autoclave. In this case, the base resin RS disposed in the first layer 110, the second layer 130, and the third layer 150 may be melted in the process of stacking the first layer 110, the second layer 130, and the third layer 150 and may permeate into a spaced space between the filer yarns of each layer.

For example, as illustrated in FIGS. 8 and 9, the base resin RS included in the first layer 110 and the third layer 150 is melted in the stacking process and permeates into the spaced space between the second fiber yarns FT2 disposed in the second layer 130, so that the surfaces of the first layer 110 and the third layer 150 may have a bent shape.

Accordingly, since the amount of the base resin RS of the first layer 110 and the third layer 150 permeating into the spaced space between the second fiber yarns FT2 disposed in the second layer 130 in the process of stacking each layer of the panel support 100 may be reduced by increasing the number per unit volume of the second fiber yarns FT2 disposed in the second layer 130 to narrow the spaced space between the second fiber yarns FT2, the degree of curvature of the surfaces of the first layer 110 and the third layer 150 may be reduced.

Referring to FIG. 10, a surface step PV for each position of the panel support 100 as viewed in the second direction DR2 is illustrated. A Y axis of the graph illustrated in FIG. 10 represents the relative degree (dimensionless) of the surface step PV, and an X axis represents a position in the second direction DR2. The inventors of the present specification measured the surface step PV for each position of the panel support 100 in which the first fiber yarn FT1 is T700 manufactured by Toray company and the second fiber yarn FT2 is T800 manufactured by Toray company as illustrated in the graph of FIG. 10 through repeated experiments.

T700 manufactured by Toray Company may have a diameter in the range of approximately 6.5 µm or more to approximately 7.5 µm or less, may have a modulus of approximately 240 GPa, and may have a carbon content of approximately 93% or less. T800 manufactured by Toray company may have a diameter in the range of approximately 4.5 µm or more to approximately 5.5 µm or less, may have a modulus of approximately 294 GPa, and may have a carbon content of approximately 96% or less. In this case, the surface step PV of the panel support 100 of the display device 1 according to an example embodiment may have a relative degree of approximately 148.5 at the maximum to 115 at the minimum. The modulus refers to a modulus of elasticity (Young's modulus) for tensile in the case of fibers.

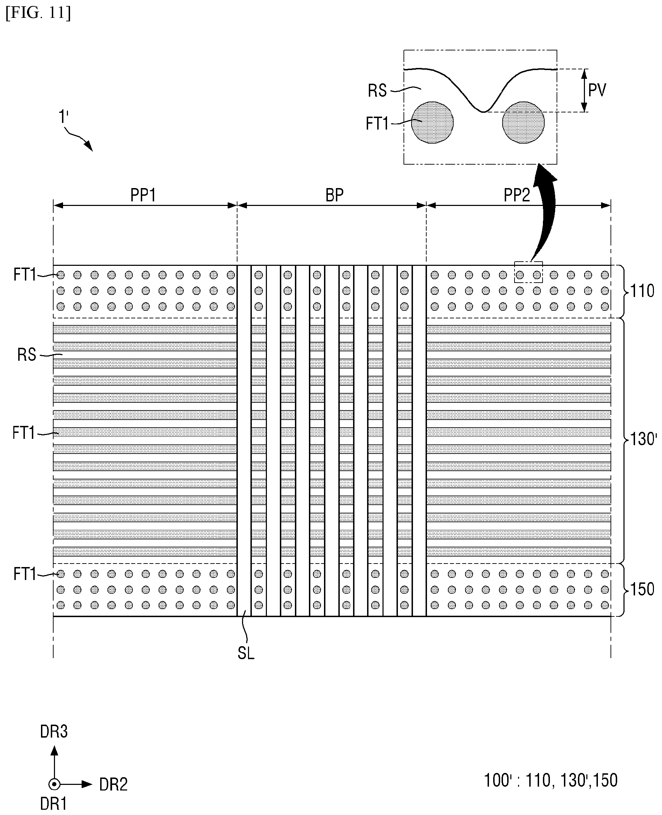

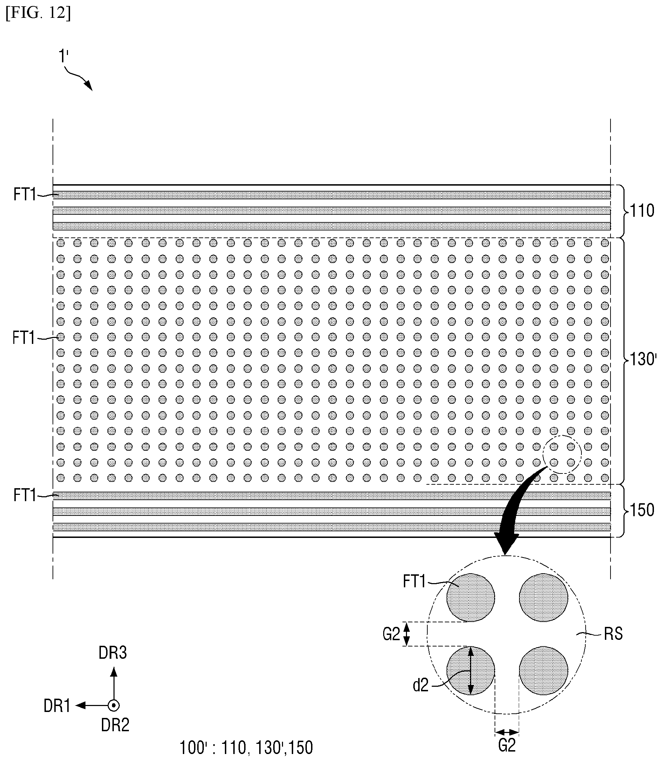

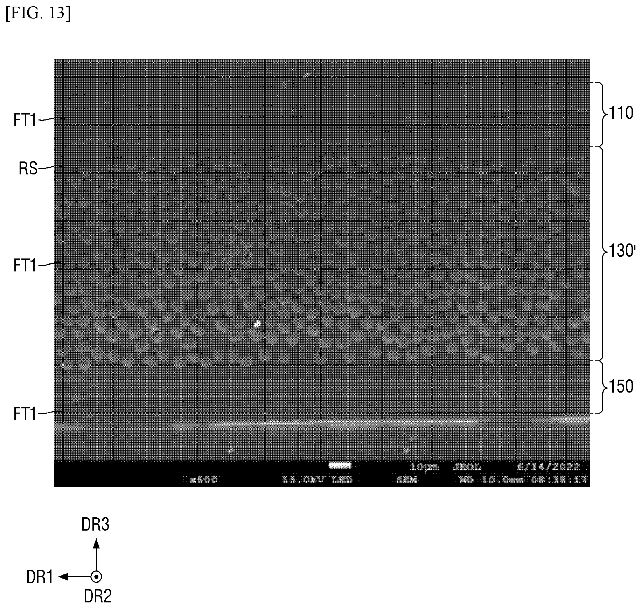

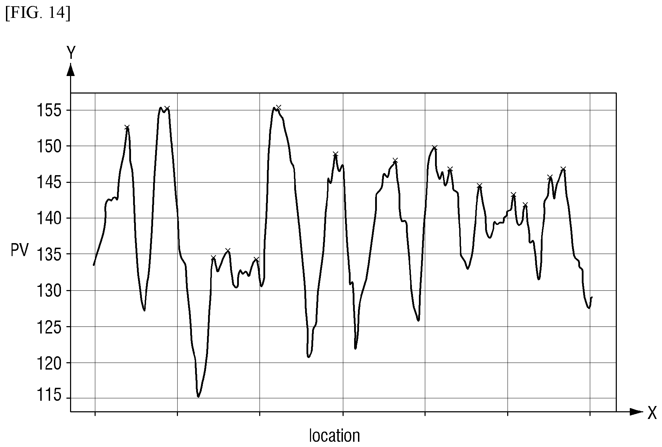

FIG. 11 is a cross-sectional view illustrating a structure of a panel support of a display device according to a comparative example. FIG. 12 is a cross-sectional view illustrating a structure of a panel support of a display device according to a comparative example. FIG. 13 is an image obtained by photographing a cross-section of the panel support of the display device according to an example embodiment, viewed from a second direction. FIG. 14 is a graph illustrating a surface step for each position of a panel support of a display device according to an example embodiment.

Referring to FIGS. 11 to 14, a panel support 100' of a display device 1' according to a comparative example is different from the panel support 100 of the display device 1 according to an example embodiment in that a second layer 130' of the panel support 100' includes the first fiber yarns FT1 as the fiber yarns, and other configurations are substantially the same or similar. In other words, the first layer 110, the second layer 130', and the third layer 150 may have the same type of fiber yarn, and the number of fiber yarns per unit volume of the first layer 110, the second layer 130', and the third layer 150 may also be the same.

In this case, a step PV formed on the surface of the first layer 110 of the display device 1' according to the comparative example illustrated in FIG. 12 may be greater than the surface step PV formed on the surface of the first layer 110 of the display device 1 according to the example embodiment illustrated in FIG. 6. This is because, as illustrated in FIG. 11 to 13, a diameter of the first fiber yarn FT1 as the fiber yarn disposed in the second layer 130' is greater than the diameter of the second fiber yarn FT2 disposed in the second layer 130 of the panel support 100 according to an example embodiment, and accordingly, the number of fiber yarns disposed per unit volume of the second layer 130' in the comparative example is reduced to increase a spaced distance between the fiber yarns of the second layer 130', so that an amount of the base resin RS of the first layer 110 and the third layer 150 permeating into the second layer 130' increases in the stacking process as described above in FIG. 7.

Referring to FIGS. 12 and 14, a surface step PV for each position of the panel support 100' as viewed in the second direction DR2 is illustrated. A Y axis of the graph illustrated in FIG. 14 represents the relative degree (dimensionless) of the surface step PV, and an X axis represents a position in the second direction DR2. The inventors of the present specification measured the surface step PV for each position of the panel support 100 in which the first fiber yarn FT1 is T700 manufactured by Toray Company as illustrated in the graph of FIG. 14 through repeated experiments.

In this case, the surface step PV of the panel support 100' of the display device 1' according to the comparative example may have a relative degree of approximately 155.4 at the maximum to 115 at the minimum.

That is, referring to FIGS. 6, 10, 12 and 14, since the surface step PV of the panel support 100 of the display device 1 according to an example embodiment has the relative degree of approximately 148.5 at the maximum to 115 at the minimum, and the surface step PV of the panel support 100' of the display device 1' according to the comparative example has the relative degree of approximately 155.4 at the maximum to 115 at the minimum, it may be seen that the surface step PV of the panel support 100 of the display device 1 according to an example embodiment is reduced compared to the surface step PV of the panel support 100' of the display device 1' according to the comparative example.

Hereinafter, other example embodiments of the display device 1 will be described. In the following example embodiments, the same components as those of the above-described example embodiment will be denoted by the same reference numerals, and an overlapping description thereof will be omitted or simplified and differences will be mainly described.

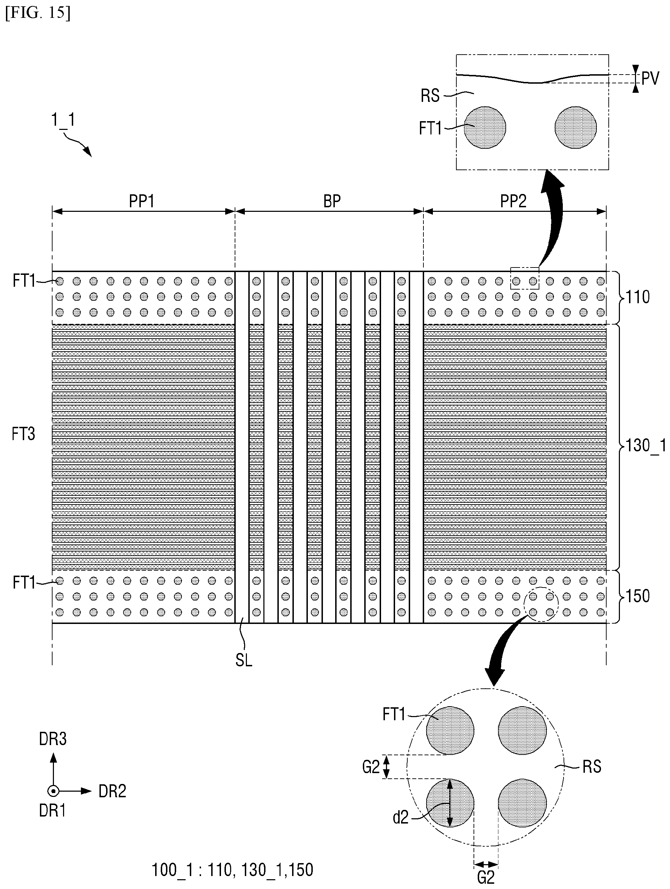

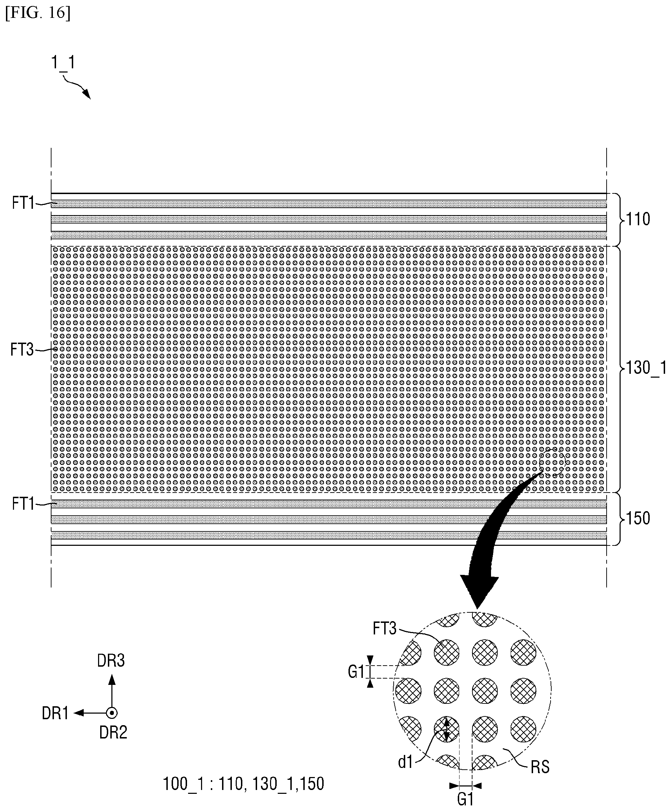

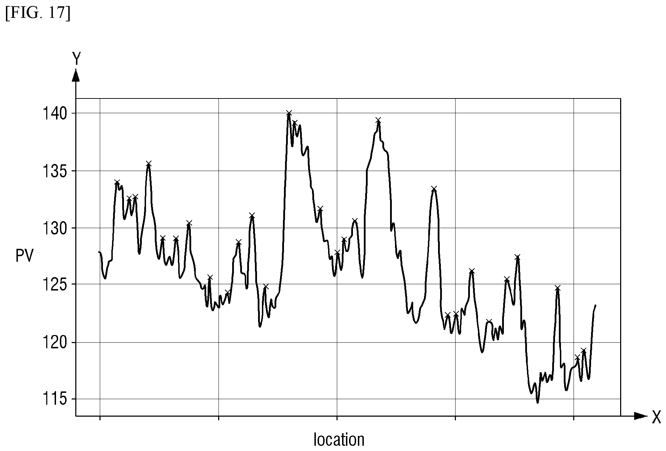

FIG. 15 is a cross-sectional view illustrating a structure of a panel support of a display device according to another example embodiment. FIG. 16 is a cross-sectional view illustrating a structure of the panel support of the display device according to the example embodiment of FIG. 15. FIG. 17 is a graph illustrating a surface step for each position of the panel support of the display device according to the example embodiment of FIG. 15.

Referring to FIGS. 15 and 16, a panel support 100_1 of a display device 1_1 according to the present example embodiment is different from the panel support 100 of the display device 1 according to an example embodiment in that a modulus of the fiber yarn disposed in a second layer 130_1 of the panel support 100_1 is greater than that of the fiber yarn disposed in the second layer 130 of the panel support 100, and other configurations are substantially same or similar.

For example, the modulus of the third fiber yarn FT3 disposed in the second layer 130_1 of the display device 1_1 according to the present example embodiment may be greater than the modulus of the second fiber yarn FT2 disposed in the second layer 130 of the display device 1 according to an example embodiment. The diameter d1 of the third fiber yarn FT3 according to the embodiment of FIGS. 15 and 16 may be in the range of approximately 4.5 µm or more and approximately 5.5 µm or less, and may be substantially the same as the diameter d1 of the second fiber yarn FT2. The diameter d1 of the third fiber yarn FT3 according to the embodiment of FIGS. 15 and 16 is substantially same as the diameter d1 of the second fiber yarn FT2 according to the embodiment of FIGS. 5 and 6. A gap G1 at which the third fiber yarns FT3 are spaced apart from each other in the second layer 130_1 may be smaller than the gap G2 (see FIG. 6) at which the first fiber yarns FT1 are spaced apart from each other in the first layer 110 or the third layer 150.

The modulus of the third fiber yarn FT3 may be greater than the modulus of the first fiber yarn FT1. In general, when the fiber yarn includes carbon fibers, there may be a correlation that the modulus increases as the carbon content increases. Accordingly, the carbon content of the third fiber yarn FT3 may be greater than the carbon content of the first fiber yarn FT1. In some example embodiments, the modulus of the third fiber yarn FT3 may be approximately 377 GPa or more, and the modulus of the first fiber yarn FT1 may be approximately 240 GPa or less, and the carbon content of the third fiber yarn FT3 may be approximately 99% or more, and the carbon content of the first fiber yarn FT1 may be approximately 93% or less, but the present disclosure is not limited thereto.

Since the second layer 130_1 of the panel support 100_1 according to the present example embodiment includes the fiber yarn having a higher modulus than that of the first layer 110 and the third layer 150 by the configuration as described above, the second layer 130_1 may have stronger rigidity than that of the first and third layers 110 and 150. Accordingly, it is possible to reduce visual recognition of the first fiber yarns FT1 disposed in the first layer 110 and the third layer 150 to the outside.

For example, as described above with reference to FIG. 7, as the base resin RS of the first layer 110 and the third layer 150 is thermally contracted in the process of stacking the first layer 110, the second layer 130, and the third layer 150, the surfaces of the first layer 110 and the third layer 150 have the bent shape. In this case, when the second layer 130_1 has the stronger rigidity than that of the first layer 110 and the third layer 150, the surface step PV generated by the thermal contraction may be reduced by reducing the degree of thermal contraction of the base resin RS of the first layer 110 and the third layer 150.

For example, the surface step PV formed in the panel support 100_1 of the display device 1_1 according to the present example embodiment may be smaller than the surface step PV (see FIG. 6) formed in the panel support 100 of the display device 1 according to an example embodiment. This is because the third fiber yarn FT3 of the display device 1_1 according to the present example embodiment has the greater modulus than that of the second fiber yarn FT2 of the display device 1 according to an example embodiment.

Referring to FIG. 17, a surface step PV for each position of the panel support 100_1 as viewed in the second direction DR2 is illustrated. A Y axis of the graph illustrated in FIG. 17 represents the relative degree (dimensionless) of the surface step PV, and an X axis represents a position in the second direction DR2. The inventors of the present specification measured the surface step PV for each position of the panel support 100_1 in which the first fiber yarn FT1 is T700 manufactured by Toray Company and the third fiber yarn FT3 is M40 manufactured by Toray Company as illustrated in the graph of FIG. 17 through repeated experiments.

T700 manufactured by Toray Company may have a diameter in the range of 6.5 µm or more to 7.5 µm or less, may have a modulus of approximately 240 GPa, and may have a carbon content of 93% or less. M40 manufactured by Toray Company may have a diameter in the range of 4.5 µm or more and 5.5 µm or less, may have a modulus of approximately 377 GPa, and may have a carbon content of 99% or less. In this case, the surface step PV of the panel support 100_1 of the display device 1_1 according to the present example embodiment may have a relative degree of approximately 140.1 at the maximum to 115 at the minimum.

That is, referring to FIGS. 10 to 17, since the surface step PV of the panel support 100 of the display device 1 according to an example embodiment has the relative degree of approximately 148.5 at the maximum to 115 at the minimum, and the surface step PV of the panel support 100_1 of the display device 1_1 according to the present example embodiment has the relative degree of approximately 140.1 at the maximum to 115 at the minimum, it may be seen that the surface step PV of the panel support 100_1 of the display device 1_1 according to the present example embodiment is reduced compared to the surface step PV of the panel support 100 of the display device 1 according to an example embodiment.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a display panel having a folding axis extending in a first direction; and
a panel support disposed on one surface of the display panel,
wherein the panel support includes:
a first layer including a first base resin and first fiber yarns extending in the first direction and dispersed in the first base resin;
a second layer disposed on the first layer, the second layer including a second base resin and second fiber yarns extending in a second direction intersecting the first direction and dispersed in the second base resin; and
a third layer disposed on the second layer, the third layer including a third base resin and third fiber yarns extending in the first direction and dispersed in the third base resin, and
wherein the number of second fiber yarns per unit volume of the second layer is greater than the number of first fiber yarns per unit volume of the first layer and the number of third fiber yarns per unit volume of the third layer.

2. The display device of claim 1, wherein a diameter of the second fiber yarn is smaller than a diameter of the first fiber yarn and a diameter of the third fiber yarn.

3. The display device of claim 2, wherein the diameter of the first fiber yarn and the diameter of the third fiber yarn are the same.

4. The display device of claim 3, wherein a spaced distance between the second fiber yarns in the second layer is smaller than a spaced distance between the first fiber yarns in the first layer and a spaced distance between the third fiber yarns in the third layer.

5. The display device of claim 4, wherein the diameter of the second fiber yarn is 4.5 µm or more and 5.5 µm or less, and
the diameter of the first fiber yarn and the diameter of the third fiber yarn are 6.5 µm or more and 7.5 µm or less.

6. The display device of claim 1, wherein a thickness of the second layer is greater than a thickness of the first layer and a thickness of the third layer.

7. The display device of claim 6, wherein the second layer is disposed between the first layer and the third layer.

8. The display device of claim 7, wherein the thickness of the first layer and the thickness of the third layer are the same as each other.

9. The display device of claim 1, wherein the first fiber yarn, the second fiber yarn and the third fiber yarn include carbon, and
a carbon content of the second fiber yarn is greater than a carbon content of the first fiber yarn and a carbon content of the third fiber yarn.

10. The display device of claim 1, wherein a modulus of the second fiber yarn is greater than a modulus of the first fiber yarn and a modulus of the third fiber yarn.

11. A display device comprising:
a display panel having a folding axis extending in a first direction; and
a panel support disposed on one surface of the display panel,
wherein the panel support includes:
a first layer including a first base resin and first fiber yarns extending in the first direction and dispersed in the first base resin;
a second layer disposed on the first layer, the second layer including a second base resin and second fiber yarns extending in a second direction intersecting the first direction and dispersed in the second base resin; and
a third layer disposed on the second layer, the third layer including a third base resin and third fiber yarns extending in the first direction and dispersed in the third base resin, and
wherein a modulus of the second fiber yarn is greater than a modulus of the first fiber yarn and a modulus of the third fiber yarn.

12. The display device of claim 11, wherein the modulus of the first fiber yarn and the modulus of the third fiber yarn are the same as each other.

13. The display device of claim 12, wherein a thickness of the second layer is greater than a thickness of the first layer and a thickness of the third layer.

14. The display device of claim 13, wherein the second layer is disposed between the first layer and the third layer.

15. The display device of claim 14, wherein the modulus of the second fiber yarn is 290 GPa or more, and
the modulus of the first fiber yarn and the modulus of the third fiber yarn are 240 GPa or less.

16. The display device comprising:
a display panel having a folding axis extending in a first direction; and
a panel support disposed on one surface the display panel,
wherein the panel support includes:
a first layer including a first base resin and first fiber yarns extending in the first direction and dispersed in the first base resin;
a second layer disposed on the first layer, the second layer including a second base resin and second fiber yarns extending in a second direction intersecting the first direction and dispersed in the second base resin; and
a third layer disposed on the second layer, the third layer including a third base resin and third fiber yarns extending in the first direction and dispersed in the third base resin, and
wherein a carbon content of the second fiber yarn is greater than a carbon content of the first fiber yarn and a carbon content of the third fiber yarn.

17. The display device of claim 16, wherein the carbon content of the first fiber yarn and the carbon content of the third fiber yarn are the same as each other.

18. The display device of claim 17, wherein a thickness of the second layer is greater than a thickness of the first layer and a thickness of the third layer.

19. The display device of claim 18, wherein the second layer is disposed between the first layer and the third layer.

20. The display device of claim 19, wherein the carbon content of the second fiber yarn is 96% or more, and
the carbon content of the first fiber yarn and the carbon content of the third fiber yarn are 93% or less.

21. A display device comprising:
a display panel having a folding axis extending in a first direction; and
a panel support disposed on one surface of the display panel and including a base resin and fiber yarns dispersed in the base resin,
wherein the fiber yarns include:
first fiber yarns extending in the first direction;
second fiber yarns extending in a second direction intersecting the first direction; and
third fiber yarns extending in the first direction,
the base resin includes:
a first portion in which the first fiber yarns are dispersed;
a second portion disposed on the first portion, the second fiber yarns being dispersed in the second portion; and
a third portion disposed on the second portion, the third fiber yarns being dispersed in the third portion, and
wherein the number of second fiber yarns per unit volume of the second portion is greater than the number of first fiber yarns per unit volume of the first portion and the number of third fiber yarns per unit volume of the third portion.

22. The display device of claim 21, wherein a diameter of the second fiber yarn is smaller than a diameter of the first fiber yarn and a diameter of the third fiber yarn.

23. The display device of claim 22, wherein a spaced distance between the second fiber yarns in the second portion is smaller than a spaced distance between the first fiber yarns in the first portion and a spaced distance between the third fiber yarns in the third portion.
